(19)

Europäisches
Patentamt

European
Patent Office

Office européen
des brevets

(11) **EP 3 133 408 B1**

(12) **EUROPEAN PATENT SPECIFICATION**

(45) Date of publication and mention
of the grant of the patent:
**17.06.2020 Bulletin 2020/25**

(51) Int Cl.:
***G01R 31/12*** *(2020.01)*     ***G01R 31/14*** *(2006.01)*

(21) Application number: **15182007.3**

(22) Date of filing: **21.08.2015**

(54) **METHOD FOR TESTING ELECTRICAL COMPONENTS**

VERFAHREN ZUM TESTEN VON ELEKTRISCHEN BAUELEMENTEN

PROCÉDÉ POUR TESTER DES COMPOSANTS ÉLECTRIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.02.2017 Bulletin 2017/08**

(73) Proprietor: **Power Diagnostix Instruments GmbH
52074 Aachen (DE)**

(72) Inventor: **GROSS, Detlev
52074 Aachen (DE)**

(74) Representative: **Neumann Müller Oberwalleney &
Partner
Patentanwälte
Overstolzenstraße 2a
50677 Köln (DE)**

(56) References cited:
**WO-A1-97/24742**     **CN-A- 102 435 922**
**US-A- 4 095 173**     **US-A1- 2011 291 666**
**US-H- H 536**

**Description**

The inventions relates to a method for testing electrical components comprising the steps of:

inputting an alternating test voltage to the electrical component,
detecting an electrical output signal that comprises partial discharge pulses due to partial discharges in the electrical component,
generating a trigger signal when a partial discharge pulse is detected, and
acquiring a time-limited measurement signal sample of one or more measurement signals in response to the trigger signal.

Such a method is described in US H536 and CN 102 435 922 A. US H536 discloses a method of locating an electrostatic discharge event in a predetermined structure by sensing electromagnetically that an electrostatic discharge event has occurred and producing a trigger signal from the electromagnetic sensing to control a recording device for the starting of time, utilizing a plurality of acoustic detectors about the structure for sensing the acoustic of the electrostatic discharge event, determining the time elapsed between the starting of time by the electromagnetic sensing and the signals sensed by the acoustic detectors and utilizing the information gained from the times sensed and the predetermined locations of the sensors to determine the location of the electrostatic discharge event in the predetermined structure.

WO 97/24742 A1 discloses a method and apparatus for automatically locating partial discharge sources in electrical transformers comprising a plurality of ultrasonic acoustical sensors placed on the outside of the transformer. The sensors are sensitive to the ultrasonic range of acoustic frequencies, converting acoustic emission signals into electrical signals. A triggering signal is generated based on electrical measurements of said partial discharge source. The presence of partial discharge is detected by radio influence voltage (RIV) or apparent charge measurements made independently by the user. The electrical trigger signals the occurrence of a partial discharge. When the system is triggered, measurements are taken at each of the acoustic sensors to record the acoustic signals that propagate from the partial discharge source through the transformer. The system calculates the time delay from the partial discharge source to each sensor and converts it into a distance based on the wave speed in the transformer. Then the approximate location of the partial discharge source is automatically determined.

Attempts to acoustically locate problems in liquid filled power transformers are as old as such transformers. Severe problems produce sound that make them already audible from distance.

PARTIAL DISCHARGE PATTERN

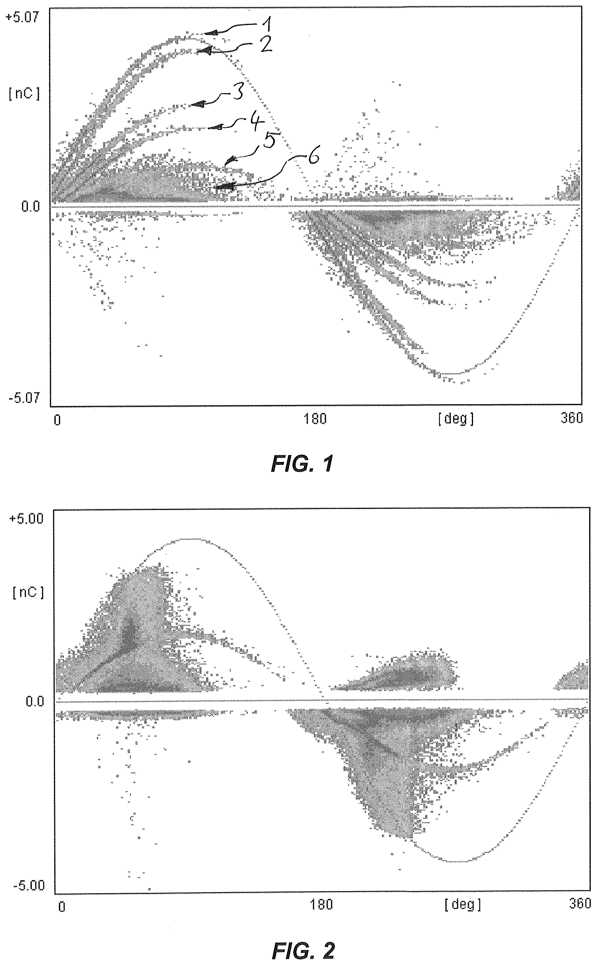

Already in the early days of high voltage insulation systems, partial discharge activity - then called corona - was understood as a prominent indicator for deterioration of insulation materials and incipient failure. In the early 1990s partial discharge detectors with pulse counting functions offering the recording of amplitude-phase-height distributions ($\varphi$-q-n-pattern) became commercially available and are described in Fruth, B., Gross, D. "Partial Discharge Signal Generation Transmission and Acquisition," in IEE Proc.-Sci. Meas. Technol., Vol. 142, No. 1, January 1995, pp. 22-28. and Fruth, B., Gross, D. "Phase resolving partial discharge pattern acquisition and spectrum analysis", Proc. of the ICPDAM, July 1994, Brisbane NSW, Australia, pp. 578-581. Further understanding of the gas discharge physics controlling the partial discharge process was gained with help of this technique. Especially distinguishing and visually separating independent discharge activities that occur at the same time in the specimen became possible. Fig. 1, for instance, shows the superimposition of at least six spherical gas inclusions in polymeric material. The X-axis (horizontal axis) displays the phase angle of the input signal in degree, as one physical property, and the Y-axis (vertical axis) displays the amplitude of the partial discharge pulses in nano Coulomb, as another physical property. Each single partial discharge pulse, which has been detected in the output signal, is displayed as one point in this graph wherein each pulse has the above mentioned two physical properties. Each partial discharge source "writes" its own trace 1, 2, 3, 4, 5, 6 depending on the size and location of the partial discharge source. The color (here the shade of grey) reflects the quantity of pulses.

Thus, with the limitations of the pulse processing capabilities due to the frequency range, partial discharge activity of different sources can be acquired and visually separated. Fig. 2 shows another example of such superimposed independent partial discharge activities, which can be clearly separated.

Transformer Acceptance Testing

According to current standards, partial discharge activities are acquired in parallel on up to nine channels for high voltage (HV), low voltage (LV), and if present, tertiary. Hence, the cross coupling ratio between the different bushing taps, i.e., the different windings is already known during calibration of the multi-channel partial discharge (PD) detector.

This calibration cross coupling, of course, reflects the properties of the winding, the differences between Y and delta, differences between disc and layer winding and the overall configuration. Thus, with inception of PD, comparison of the calibration cross coupling versus the partial discharge appearance on the different taps is an indication of the location. Further information is gained, if comparing the time domain signals of the different taps. Here, signals having a cross talk with an identical polarity indicate mere coupling, whereas signals with an opposite polarity show that this part of the winding forms the opposite electrode of the partial discharge site and, hence, the discharge activity is between the two electrodes.

ACOUSTIC SIGNALS IN POWER TRANSFORMERS

Within a power transformer acoustic signals of various sources are present. Besides the often quite faint signals of partial discharge activity, partly strong and dominant signals hamper sensitive acquisition.

The Barkhausen noise is one of the most prominent sources of such acoustic signals being present in an energized transformer. This noise originates from discontinuous changes of the orientation of clusters in ferromagnetic materials during magnetization and demagnetization. As such "clicks" of the Barkhausen effect in common ferro-magnetic materials used in transformer design have a rise time of a couple of $\mu$s, the resulting signals reach up into several tens of kHz in frequency domain. Of course, Barkhausen noise does not only originate in core material, but in any ferromagnetic material that is being magnetized. Here, as the piezoelectric transducers are usually placed on the tank wall, stray flux in wall material and wall shunts is of importance. However, in case of transformer acceptance testing in the lab, this effect is less significant, as such tests are typically made at higher power frequencies, and, hence, the flux and the resulting Barkhausen noise is proportionally lower.

Additionally, there are other mechanical sources, such as pumps, tap changer, vibration, and thermally induced clicking sounds. Further, atmospheric sources (rain, ice, and wind) hamper field tests.

Acoustic Emission of PD Sources

The electrical signal of partial discharge under Nitrogen atmosphere has a rise time of about 1 ns and, hence, posing a literally instantaneous excitation for the acoustic emission under transformer oil, which is found in a frequency range up to about 300 kHz. Thus, at its origin the acoustic signal shows an even amplitude spectrum and a sharp pressure increase at the wave front. However, this ideal situation persists only for a clear oil path with homogenous properties.

Properties of Transformer Materials

Transformer oil offers a good signal transmission of the acoustic pressure wave. However, the transmission speed is temperature dependent. At 20°C the velocity of propagation is 1415 ms$^{-1}$, while it is typically 1200 ms$^{-1}$ at 80°C. Solid materials, such as steel, wood, pressboard, and fiber-glass do offer besides the compression wave also the shear wave, whereas the velocity of propagation differs for both modes. Moreover, some structured materials, such as pressboard show different transmission properties depending on the orientation of the fibers.

Especially, the speed of the compression wave in steel, as used for transformer tanks is substantially higher than the acoustic transmission in oil. Here, the compression wave (longitudinal wave) travels at a speed of about 5900 ms$^{-1}$, which is more than four times faster than the transmission in oil. The shear wave (transverse wave) in steel propagates at about 3200 ms$^{-1}$.

Triangulation

Triangulation is based on the differences in arrival time of signals at different receivers or sensors. Generally, the location is calculated with solving the set of equations of the sphere functions (1).

$$(x-x_1)^2 + (y-y_1)^2 + (z-z_1)^2 = (v \cdot t_1)^2$$
$$(x-x_2)^2 + (y-y_2)^2 + (z-z_2)^2 = (v \cdot t_2)^2 \tag{1}$$
$$(x-x_3)^2 + (y-y_3)^2 + (z-z_3)^2 = (v \cdot t_3)^2$$

This basic, "classical" triangulation requires two central conditions fulfilled for a tank-type specimen: Firstly, the interior of the tank must be homogeneously filled with a liquid, i.e., otherwise empty and, secondly, the tank wall must be a thin membrane without any lateral transmission capabilities. In case, of course, a location is an easy task.

Non-Ideal Conditions

However, there is no real-life transformer fulfilling the above-mentioned conditions and, hence, various side effects of the non-ideal, real-life transformer must be taken into consideration, when attempting an acoustic location:

Tank Wall

As the tank wall has a certain thickness, lateral transmission has to be considered. Thus, for a given sound source location, there is a corner angle within which direct oil path signal arrives the earliest. This angle is a simple function of the velocity of the compression waves in oil vs. steel (2).

$$\propto = arctan \frac{v_{oil}}{v_{steel}} \qquad\qquad (2)$$

Thus, the fastest signal path is partly in steel for any incoming signal under an angle of more than 14°, given the aforementioned ratio of about 0.25 between velocities in oil vs. steel. The consequence is that two neighboring sensors having both a viewing angle of more than 14° cannot produce a valid location result based on the first arrival. In theory, the incoming oil-path signal creates a distinct increase in magnitude over the leading tank wall signal, if the signal path deviates more than 14° from the straight view. The two lower traces of figures 13 show the signal of such case with the smaller leading steel signal. However, in real-life situations, the signal paths often are more complex and such nice signals are not so common.

Wave Guide

If, for instance, the partial discharge source is located at the far tip of a stick, the sound travels inside the stick approximately 40% faster than in the surrounding oil. At the stick's near end, this sound is then radiated and leads to a false location pointing to this near tip, but indicating a closer location.

Acoustic Window

Acoustic emission of hidden partial discharge, for instance on the core surface, behind a stack of insulation material on top of a LV winding, a buried glue drop with an air bubble, or an otherwise hid-den source may take an angled path to the sensor. For instance, the sound may emit from an oil channel or between sticks. In case, the triangulation falsely points to the oil channel emitting the signal, but indicates the length of the overall path.

Reflection

Of course, acoustic waves undergo reflection within the structure of a transformer and its tank. However, in principle reflections do arrive after the first, direct signal and, hence, are not likely to hamper a correct triangulation. On the other hand, identification of reflected signal could help to validate the interpretation of acquired signal.

TRIGGER METHODS

Two main methods exist to trigger acoustic triangulation. Both have their advantages and disadvantages under different applications.

All Acoustic

In general, a location is possible based on just three acoustic signals, when solving the equations of the sphere functions. However, as mentioned above, various signals of other sources than partial discharge are present in a transformer especially in the field. Here, the placement of sensors is a key point and it must be avoided to combine signals to fake location that do not belong together.

However, under field conditions it can be advantageous that besides placing sensors, no further installation or interference is needed on site.

Standard Electrical Trigger

Using electrical trigger for the acoustic triangulation is the predominant method for test room applications. Here, the usual situation is that a transformer failed to complete the acceptance test and, hence, focus is on finding the root cause of the partial dis-charge. Therefore, eliminating any acoustic signal that is not caused by partial discharge is appreciated. Further, using averaging techniques based on the precise electrical trigger helps to improve the signal-to-noise ratio and to reduce the impact of the signals caused by the Barkhausen effect.

Typically, an analog output of a partial discharge detector is taken as trigger. Preferably, wide band detectors are used, as their internal signal processing causes only a delay of few microseconds, which can be neglected against the acoustic travel time.

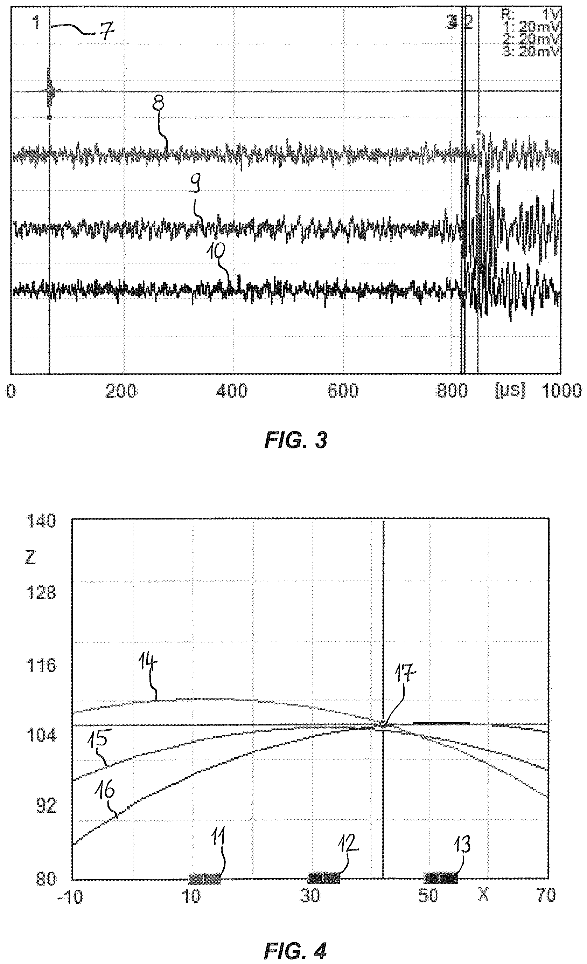

In a field situation it may be more convenient using a split-core radio frequency (RF) current transformer for instance on a neutral or ground lead as trigger source. Likewise, ultra-high frequency (UHF) signals captured with drain valve sensors can act as trigger source to start the acquisition. Generally, of course, the electrical signal is analyzed beforehand to make sure that it reflects the partial discharge signal in question. Fig. 3 shows a typical trace of such a measurement with an electric trigger signal 7 and three measurement signals 8, 9, 10 of acoustic sensors in a row. The X-axis (horizontal axis) displays the time in mico-seconds ($\mu s$) and the Y-axis displays the amplitude of the signals.

Fig. 4 shows the corresponding location result for the "flat problem", as the three sensors, first acoustic sensor 11, second acoustic sensor 12 and third acoustic sensor 13, are mounted in a horizontal (or vertical) line. The X-axis (horizontal axis) of the diagram displays the position in X-direction in centimeters (cm) and the Y-axis displays the position in Y-direction. The main point of the third sensor 13 is to validate the results of the first and second sensor 11, 12. The distance calculation, displayed as circles 14, 15, 16 for each sensor, can be set to reflect the travel path in the tank wall. In case, the circle changes into a line for an angle above the corner angle. The intersection point 17 reflects the position of the partial discharge source.

In an iterative process, the sensors are replaced to give a clear signal within the corner angle. With the then found location result for the said flat problem, the sensors are swapped from horizontal to vertical (or vice versa) to solve the second flat problem.

Here, the software always tilts the previous result layer using the newfound location. With a clear oil path, this leads to a precision of about $\pm 2$ cm.

However, the "standard" electrical trigger runs into problems in case of high magnitude noise, high repetition rate noise signals, and several parallel activities competing during averaging.

SUMMARY OF THE INVENTION

It is the object of the invention to provide a method for testing electrical components which improves the signal acquisition under difficult situations.

The object is solved by a method according to claim 1. Preferred embodiments are defined exemplary in the dependent claims.

According to the invention the trigger signal is only generated if if at least the phase angle $\varphi$ of the voltage of the input signal and the amplitude q of the partial discharge pulse of the electrical output signal are within a predefined trigger condition area. The trigger condition may be defined such that it is likely that the time-limited measurement signal samples of at least one measurement signal in response to the trigger signal come from the same partial discharge source. The acquired measurement signal samples are then assigned to a cluster or "basket" of measurement signal samples corresponding to the predefined trigger condition.

Using this method it is possible to focus the measurement to one partial discharge source. Alternatively, a plurality of trigger conditions may be defined each having a separate cluster ("basket") for the measurement signal samples of each partial discharge source.

A trigger condition area is a combination of at least two physical properties or parameters such as phase angle of the test voltage, amplitude of the partial discharge pulse, time, frequency, acoustic emission and light emission. A trigger condition area is, hence, a two- or more dimensional vector.

A trigger condition area comprises a range of different combinations of these properties, wherein the term "area" defines a two- or more dimensional area.

The physical properties phase angle of the voltage of the input siganl and amplitude of the partial discharge pulse of the electrical output signal are used. These physical properties are part of the $\varphi$-q-n-pattern typically used for partial discharge analyzes. These $\varphi$-q-n-pattern can be modified such that the trigger condition areas are marked within the $\varphi$-q-n-pattern and used for the generation of the trigger signal or trigger signals.

A plurality measurement signal samples, which have been assigned to one cluster, can be averaged in order to eliminate noise.

The at least one of the measurement signals is the electrical output signal and/or electrical signals of acoustic sensors.

For determining the location of partial discharge sources a plurality of acoustic sensors can be places to the electrical component at different positions. Electrical acoustic sensor signals comprising pulses due to partial discharge activity are acquired, wherein the electrical acoustic sensor signals (as measurement signals) represent acoustic emission signals detected by the acoustic sensors. The acoustic sensors are preferably placed to the surface of a housing of the electrical component.

During a first test run the acoustic sensors may be arrange in a first plane, preferably in a horizontal plane, traversing the electrical component. During a second test run the acoustic sensors are then arrange in a second plane, preferably in a vertical plane, traversing the electrical component. This procedure divides the three-dimensional problem of locating the partial discharge source into two two-dimensional or "flat" problems. This can be done iteratively in several successive sequences.

In a next step the approximate location of the partial discharge source can be determined automatically on the basis of the time of detection of the pulses of the electrical acoustic sensor signals and the position of the acoustic sensors by triangulation.

A preferred embodiment is explain by way of example in the following figures, wherein

Figure 1    is an example of a φ-q-n-pattern of several voids (partial discharge activities);

Figure 2    is a further example of a φ-q-n-pattern showing several independent partial discharge activities;

Figure 3    shows an averaged acoustic signal with an electrical trigger signal;

Figure 4    shows the location result for the signals according to Fig. 3;

Figure 5    is an example of a φ-q-n-pattern with φ-q-trigger condition areas according to the invention;

Figure 6    shows an example of one set of averaged traces of measurement signals in one of the clusters;

Figure 7    a high-voltage transformer with acoustic sensors and first and second trigger condition areas;

Figure 8    a high-voltage transformer according to Fig. 7 and a different trigger condition areas; and

Figure 9    a high-voltage transformer with electrical sensors and first and second trigger condition areas.

As mentioned already above, the "standard" electrical trigger runs into problems in case of high magnitude noise, high repetition rate noise signals, and several parallel activities competing during averaging. Here, a trigger based on a trigger condition, including a trigger condition comprising a range of different combinations of the at least two physical properties (trigger condition area), such as a φ-q-n-pattern based trigger condition, greatly improves the signal acquisition under difficult situations.

This function can be achieved by using a multi-channel parallel partial discharge detector. Current versions of this instrument offer a built-in 100 Msample digital storage oscilloscopes (DSO) for each channel of up to nine parallel acquisition channels.

Besides the standard mere level-based trigger function, as found usually with oscilloscopes, here, the circuits that accumulate the φ-q-n pattern can provide a smart trigger to have only signals contributing to the averaging process that are likely to come from the same source.

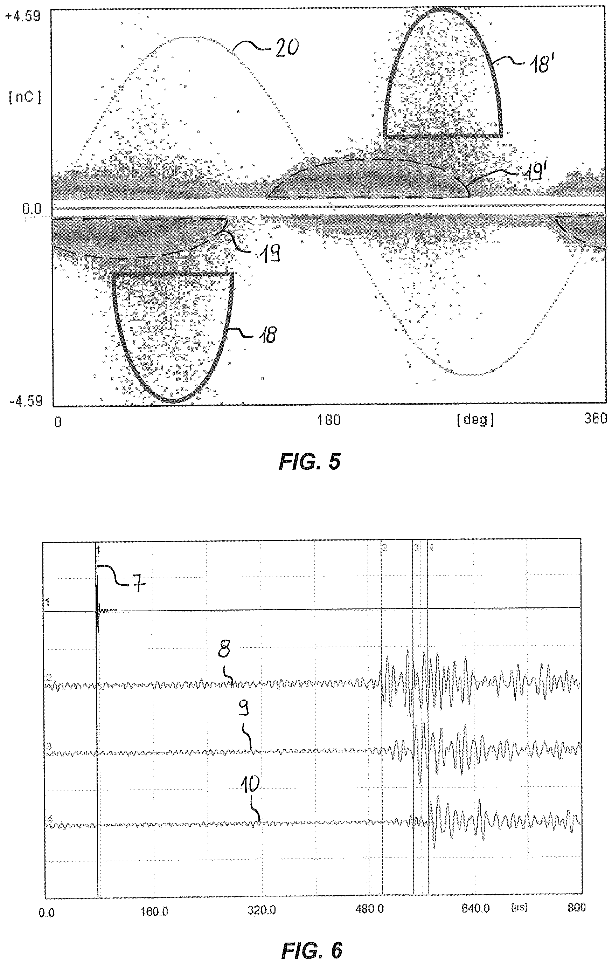

Practically, the trigger is set using a φ-q-editor to mark trigger condition areas to provide a trigger within a φ-q-n-pattern acquired on the unit under test. Fig. 5 shows an example of such partial discharge pattern and a first trigger condition areas 18, 18' and a second trigger condition areas 19, 19' to provide a trigger, while all other pulses are neglected. Each of the trigger condition areas comprises two partial areas 18, 18', 19, 19'. Technically, the instrument can handle up to eight independent trigger condition areas 18, 18', 19, 19'. Fig. 5 also depicts the sinus wave of the input signal 20. The X-axis (horizontal axis) displays the phase angle of the input signal in degree, as one physical property, and the Y-axis (vertical axis) displays the amplitude of the partial discharge pulses in nano Coulomb, as another physical property.

Subsequently, the instrument acquires the traces of the up to eight acoustic channels into independent averaging clusters or "baskets" for each trigger class, which then rules out remaining "wrong" traces. The channels are particularly acoustic channels for tracing electronic signals of acoustic sensors.

As this function is implemented in the (hardware-) state machine routine to accumulate the φ-q-n pattern of the (electrical PD) trigger channel, the over-all performance of the instrument does not suffer from the additional task.

This allows now firstly to get valid averaging results for multiple sources even with partial discharge activities having extremely different repetition rates and with signals buried in high-level or scattered impulse noise.

To minimize confusion, all traces (acoustic channels) belonging to one trigger condition area 18, 18', 19, 19' are displayed in the same color (here replaced by a continuous line for the first trigger condition area 18, 18' and by a broken like for the second trigger condition area 19, 19'). The sets of separately averaged traces can be shown different colors, while the trigger signal and the to reference can also be displayed in a specific color.

The measurement signals 8, 9, 10 of three different acoustic sensors corresponding to one of the trigger areas 18, 18', 19, 19' shown in Fig.5 is depicted in Fig. 6.

Of course, displaying the different trigger classes can be selected or disabled, as simultaneous display of activities at a comparable distance can produce quite confusing results.

Instead of showing further trigger classes, the instrument can also be set to display the triggered signals of one class and their complement, i.e., every signal that surpasses a basic trigger threshold and does not fall into the marked area. This helps keeping an eye on less dominant activities that may be in the view of the sensors, but other-wise will not make it up in the averaging statistics. Besides acquiring and averaging signals of acoustic sources, this function can also be used to analyze the time domain properties of electrical partial discharge signal as described above. Here, likewise, the time domain properties can be assigned to individual activities selected and marked in the φ-q-n-pattern. This gives especially further insight for deeply buried sources, where no acoustic signal can be detected.

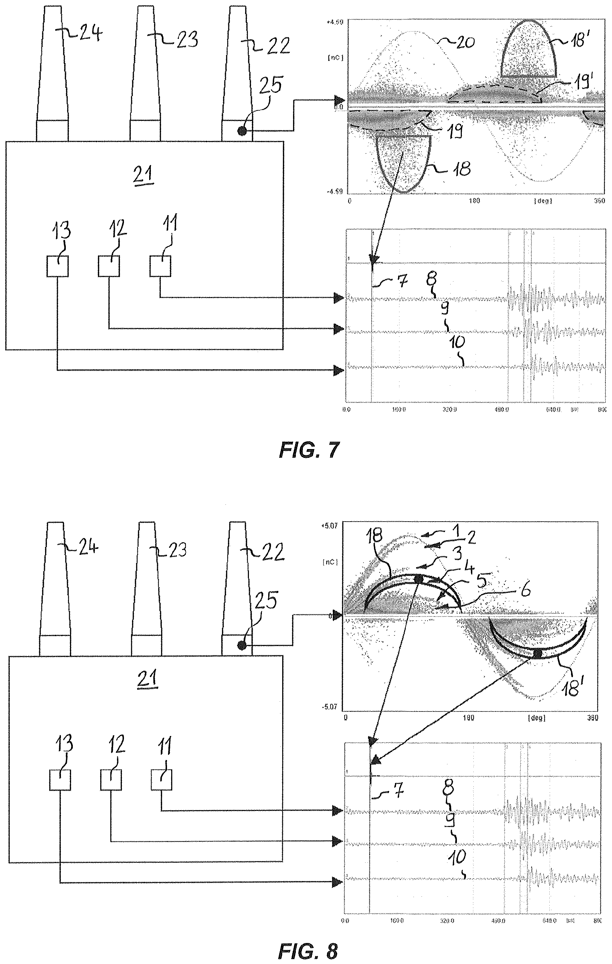

Fig. 7 depicts a high-voltage transformer 21 as electrical component which is to be tested. Three acoustic sensors 11, 12, 13 are arranged in a horizontal row for a first measurement as described above. The acoustic sensors 11, 12, 13 are fixed to a surface of a wall of a tank (housing) of the transformer 21. The acoustic sensors 11, 12, 13 deliver the signals 8, 9, 10 as exemplary shown in Fig. 7, which are identical to the signals 8, 9, 10 as shown in Fig. 6.

The transformer 21 has three connectors 22, 23, 24, one of which is equipped with an electrical sensor 25 for delivering the φ-q-n pattern of the electrical partial discharge events. The retrieved φ-q-n pattern is exemplary depicted in Fig. 7, which is identical to the φ-q-n pattern as disclosed in Fig. 5. In the example according to Fig. 7 the user has marked the same trigger condition areas 18, 18', 19, 19' as in Fig. 5.

Fig. 8 depicts the same high-voltage transformer 21 and sensor arrangement as Fig. 7. In contrary to Fig. 7 the measured φ-q-n pattern as shown in Fig. 8 is different due to different partial discharge events. As the result according to the φ-q-n pattern is different to that of Fig. 7 the user has marked a different trigger condition area 18, 18'.

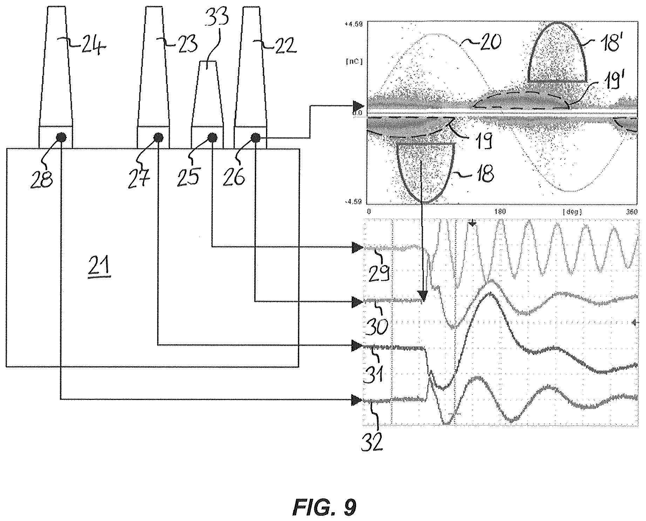

Fig. 9 shows another high-voltage transformer 21' having four electrical connectors 22, 23, 24, 33. All of the electrical connectors 22, 23, 24, 33 are equipped with electrical sensors 25, 26, 27, 28. Three of these electrical sensors 26, 27, 28 deliver measurement signals 30, 31, 32 and one of the electrical sensors 25 is used to deliver the trigger signal 29, as also depicted in Fig. 9. The φ-q-n pattern derived by the measurement signal 30 of one of the electrical sensors 26 is in this example identical to that according to Fig. 7 and Fig. 5, as well as the marked trigger condition areas 18, 18', 19, 19'.

Reference numerals

| 1 | trace of partial discharge pulses |
| 2 | trace of partial discharge pulses |
| 3 | trace of partial discharge pulses |
| 4 | trace of partial discharge pulses |
| 5 | trace of partial discharge pulses |
| 6 | trace of partial discharge pulses |
| 7 | trigger signal |
| 8 | measurement signal of acoustic sensor |
| 9 | measurement signal of acoustic sensor |
| 10 | measurement signal of acoustic sensor |
| 11 | first acoustic sensor |
| 12 | second acoustic sensor |
| 13 | third acoustic sensor |
| 14 | circle |
| 15 | circle |
| 16 | circle |
| 17 | intersection point |
| 18, 18' | first trigger condition area, partial area |
| 19, 19' | second trigger condition area, partial area |

| 20 | input signal |
| 21, 21' | transformer |
| 22 | connector |
| 23 | connector |
| 24 | connector |
| 25 | electrical sensor |
| 26 | electrical sensor |
| 27 | electrical sensor |
| 28 | electrical sensor |
| 29 | trigger signal |
| 30 | measurement signal of electrical sensor |
| 31 | measurement signal of electrical sensor |
| 32 | measurement signal of electrical sensor |
| 33 | connector |

**Claims**

1. Method for testing electrical components comprising the steps of:

   - inputting an input signal (20) having an alternating voltage to the electrical component (21),
   - detecting an electrical output signal (29, 30, 31, 32) that comprises partial discharge pulses due to partial discharges in the electrical component (21),
   - generating a trigger signal (7) when a partial discharge pulse is detected, and
   - acquiring time-limited measurement signal samples of at least one measurement signal (8, 9, 10) in response to the trigger signal (7),

   **characterized in**
   **that** the trigger signal (7) is only generated if at least the phase angle ($\varphi$) of the voltage of the input signal and the amplitude (q) of the partial discharge pulse of the electrical output signal are within a predefined trigger condition area (18, 18', 19, 19'), and
   **that** the acquired time-limited measurement signal samples of the at least one measurement signal, being the electrical output signal and/or electric signals of acoustic sensors are assigned to a cluster of measurement signals corresponding to the predefined trigger condition area.

2. Method according to claim 1,

   **characterized in**
   **that** a plurality of trigger condition areas (18, 18', 19, 19') are predefined and that each trigger condition area (18, 18', 19, 19') has a corresponding cluster of measurement signals.

3. Method according to any one of the preceding claims,

   **characterized in**
   **that** the trigger signal (7) is only generated if at least one further physical property selected from the group consisting of time, frequency, acoustic emission and light emission is within the predefined trigger condition area (18, 18', 19, 19').

4. Method according to any one of the preceding claims further comprising the step of

   - averaging a plurality of said measurement signal samples.

5. Method according to any one of the preceding claims further comprising the step of

   - placing a plurality of acoustic sensors (11, 12, 13) to the electrical component (21) at different positions,
   - acquiring the electrical acoustic sensor signals (8, 9, 10) comprising pulses due to partial discharge activity, wherein the electrical acoustic sensor signals (8, 9, 10) represent acoustic emission signals detected by the acoustic sensors (11, 12, 13).

**6.** Method according to claim 5 further comprising the step of

- automatically determining the approximate location of the partial discharge source on the basis of the time of detection of the pulses of the electrical acoustic sensor signals (8, 9, 10) and the position of the acoustic sensors (11, 12, 13) by triangulation.

**7.** Method according to any one of claims 5 or 6,

**characterized in**
**that** the acoustic sensors (11, 12, 13) are placed to the surface of a housing of the electrical component (21).

**8.** Method according to any one of claims 5 to 7,

**characterized in**
**that** during a first test run the acoustic sensors (11, 12, 13) are arrange in a first plane, preferably in a horizontal plane, traversing the electrical component (21).

**9.** Method according to claim 8,

**characterized in**
**that** during a second test run the acoustic sensors (11, 12, 13) are arranged in a second plane, preferably in a vertical plane, traversing the electrical component (21).


**Patentansprüche**

**1.** Verfahren zum Prüfen von elektrischen Komponenten, umfassend die Schritte:

- Einspeisen eines Eingangssignals (20) mit einer Wechselspannung zu der elektrischen Komponente (21),
- Erfassen eines elektrischen Ausgangssignals (29, 30, 31, 32), das Teilentladungsimpulse aufgrund von Teilentladungen in der elektrischen Komponente (21) umfasst,
- Erzeugen eines Triggersignals (7), wenn ein Teilentladungsimpuls erkannt wird, und
- Erfassen von zeitlich begrenzten Messsignalproben von mindestens einem Messsignal (8, 9, 10) als Reaktion auf das Triggersignal (7),

**dadurch gekennzeichnet,**
**dass** das Triggersignal (7) nur erzeugt wird, wenn mindestens der Phasenwinkel (?) der Spannung des Eingangssignals und die Amplitude (q) des Teilentladungsimpulses des elektrischen Ausgangssignals innerhalb eines vordefinierten Triggerbedingungsbereichs (18, 18', 19, 19') liegen, und
**dass** die erfassten zeitlich begrenzten Messsignalproben des mindestens einen Messsignals, das das elektrische Ausgangssignal und/oder elektrische Signale von akustischen Sensoren ist, einem Cluster von Messsignalen zugeordnet werden, das dem vordefinierten Triggerbedingungsbereich entspricht.

**2.** Verfahren nach Anspruch 1, **dadurch gekennzeichnet,**
**dass** eine Vielzahl von Triggerbedingungsbereichen (18, 18', 19, 19') vordefiniert sind und dass jeder Triggerbedingungsbereich (18, 18', 19, 19') einen entsprechenden Cluster von Messsignalen aufweist.

**3.** Verfahren nach einem der vorangehenden Ansprüche, **dadurch gekennzeichnet,**
**dass** das Triggersignal (7) nur erzeugt wird, wenn mindestens eine weitere physikalische Eigenschaft, ausgewählt aus der Gruppe bestehend aus Zeit, Frequenz, akustische Emission und Lichtemission, innerhalb des vordefinierten Triggerbedingungsbereichs (18, 18', 19, 19') liegt.

**4.** Verfahren nach einem der vorhergehenden Ansprüche, ferner umfassend den Schritt

- Mittelung einer Vielzahl der Messsignalproben.

**5.** Verfahren nach einem der vorhergehenden Ansprüche, ferner umfassend den Schritt

**EP 3 133 408 B1**

- Anordnen einer Vielzahl von akustischen Sensoren (11, 12, 13) an der elektrischen Komponente (21) an verschiedenen Positionen,
- Erfassen der elektrischen akustischen Sensorsignale (8, 9, 10), die Impulse aufgrund von Teilentladungsaktivität umfassen, wobei die elektrischen akustischen Sensorsignale (8, 9, 10) akustische Emissionssignale darstellen, die von den akustischen Sensoren (11, 12, 13) erfasst werden.

6. Verfahren nach Anspruch 5, ferner umfassend den Schritt

- automatisches Bestimmen der ungefähren Position der Teilentladungsquelle auf der Grundlage des Erfassungszeitpunkts der Impulse der elektrischen akustischen Sensorsignale (8, 9, 10) und der Position der akustischen Sensoren (11, 12, 13) durch Triangulation.

7. Verfahren nach einem der Ansprüche 5 oder 6,
**dadurch gekennzeichnet,**
**dass** die akustischen Sensoren (11, 12, 13) an der Oberfläche eines Gehäuses der elektrischen Komponente (21) angeordnet werden.

8. Verfahren nach einem der Ansprüche 5 bis 7, **dadurch gekennzeichnet,**
**dass** während eines ersten Prüflaufs die akustischen Sensoren (11, 12, 13) in einer ersten Ebene, vorzugsweise in einer horizontalen Ebene, die das elektrische Bauteil (21) durchläuft, angeordnet werden.

9. Verfahren nach Anspruch 8, **dadurch gekennzeichnet,**
**dass** während eines zweiten Prüflaufs die akustischen Sensoren (11, 12, 13) in einer zweiten Ebene, vorzugsweise in einer vertikalen Ebene, die das elektrische Bauteil (21) durchläuft, angeordnet werden.

## Revendications

1. Procédé de test de composants électroniques comprenant les étapes consistant à :

   - entrer un signal d'entrée (20) ayant une tension alternative dans le composant électronique (21) ;
   - détecter un signal de sortie électrique (29, 30, 31, 32) qui comprend des impulsions de décharge partielle dues à des champs partiels dans le composant électrique (21),
   - générer un signal de déclenchement (7) lorsqu'une impulsion de décharge partielle est détectée, et
   - acquérir des échantillons de signal de mesure limités dans le temps d'au moins un signal de mesure (8, 9, 10) en réponse au signal de déclenchement (7),

   **caractérisé en ce que** le signal de déclenchement (7) est généré uniquement si au moins l'angle de phase ($\varphi$) de la tension du signal d'entrée et l'amplitude (q) de l'impulsion de décharge partielle du signal de sortie électrique sont dans les limites d'une zone de condition de déclenchement prédéfinie (18, 18', 19, 19'), et que les échantillons d'un signal de mesure limités dans le temps acquis d'au moins un signal de mesure, étant le signal de sortie électrique et/ou des signaux électriques de capteur acoustique sont assignés à une grappe de signaux de mesures correspondant à la zone de condition de déclenchement prédéfinie.

2. Procédé selon la revendication 1,

   **caractérisé en ce que**
   une pluralité de zones de conditions de déclenchement (18, 18', 19, 19') sont prédéfinies et que chaque zone de conditions de déclenchement (18, 18', 19, 19') possède une grappe correspondante de signaux de mesure.

3. Procédé selon une quelconque des revendications précédentes,

   **caractérisé en ce que**
   le signal de déclenchement (7) est généré uniquement si au moins une propriété physique supplémentaire sélectionnée dans le groupe composé du temps, de la fréquence, de l'émission acoustique et de l'émission lumineuse est dans les limites d'une de la zone de condition de déclenchement prédéfinie (18, 18', 19, 19').

4. Procédé selon une quelconque des revendications précédentes, comprenant en outre l'étape consistant à :

- calculer une moyenne d'une pluralité desdits échantillons de signal de mesure.

5. Procédé selon une quelconque des revendications précédentes, comprenant en outre l'étape consistant à :

- placer une pluralité de capteurs acoustiques (11, 12, 13) vers le composant électrique (21) à différentes positions,
- acquérir les signaux de capteur acoustique électrique (8, 9, 10) comprenant des impulsions dues à une activité de décharge partielle, dans lequel les signaux de capteurs acoustiques électriques (8, 9, 10) représentent des signaux d'émission acoustique détectée par les capteurs acoustiques (11, 12, 13).

6. Procédé selon la revendication 5, comprenant en outre l'étape consistant à :

- déterminer automatiquement la localisation approximative de la source de décharge partielle sur la base de l'heure de détection des impulsions des signaux de capteurs acoustiques électriques (8, 9, 10) et la position des capteurs acoustiques (11, 12, 13) par triangulation.

7. Procédé selon une quelconque des revendications 5 ou 6,

**caractérisé en ce que**
les capteurs acoustiques (11, 12, 13) sont placés sur la surface d'un boîtier du composant électrique (21).

8. Procédé selon une quelconque des revendications 5 à 7,

**caractérisé en ce que**
pendant un premier essai de test les capteurs acoustiques (11, 12, 13) sont disposés dans un premier plan, de préférence dans un plan horizontal, traversant le composant électrique (21).

9. Procédé selon la revendication 8,

**caractérisé en ce que**
pendant un second essai de test les capteurs acoustiques (11, 12, 13) sont disposés dans un second plan, de préférence dans un plan vertical, traversant le composant électrique (21).

**FIG. 1**

**FIG. 2**

**FIG. 3**

**FIG. 4**

**FIG. 5**

**FIG. 6**

**FIG. 7**

**FIG. 8**

**FIG. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US H536 A
- CN 102435922 A
- WO 9724742 A1

### Non-patent literature cited in the description

- **FRUTH, B. ; GROSS, D.** Partial Discharge Signal Generation Transmission and Acquisition. *IEE Proc.-Sci. Meas. Technol.,* January 1995, vol. 142 (1), 22-28
- **FRUTH, B. ; GROSS, D.** Phase resolving partial discharge pattern acquisition and spectrum analysis. *Proc. of the ICPDAM,* July 1994, 578-581